# EUROPEAN PATENT APPLICATION

(11) **EP 4 733 881 A1**
(43) Date of publication of application: **29.04.2026**
(21) Application number: 25209005.5
(22) Date of filing: 15.10.2025
(51) Int. Cl.: G06F 1/06, G06F 1/10, G06N 3/063, G11C 7/10

(54) **SELF-CLOCKING IN A MULTI-TILE IN-MEMORY COMPUTATION (IMC) NEURAL PROCESSING UNIT (NPU)**

(30) Priority: 28.10.2024 US 202463712830 P; 03.10.2025 US 202519349224
(71) Applicant: STMicroelectronics International N.V., 1228 Plan-les-Ouates, Geneva (CH)
(72) Inventor: AYODHYAWASI, Manuj, 201304 Noida (IN); CHAWLA, Nitin, 201304 Noida (IN); RAWAT, Harsh, 121006 Faridabad (IN); CHELANI, Vikas, 201301 Noida (IN)
(74) Representative: Casalonga

(57) **Abstract**

An internal computation clock signal is derived from a clock signal and includes a number of pulses within each clock signal period equal to a number of in-memory computation (IMC) processing tiles of a tile cluster that are included within a stall domain of a neural processing circuit. The pulses of the internal computation clock signal are selectively gated to generate corresponding internal clock signals applied to respective IMC processing tiles of the tile cluster within the stall domain. Timing of IMC processing tile processing operations is controlled by the applied internal clock signal. Data communications output from the IMC processing tiles are time multiplexed over a shared resource bus to a shared compute circuit for processing in response to the internal computation clock signal.

## Description

### TECHNICAL FIELD

Embodiments herein relate to a neural processing unit (NPU) utilizing multiple interconnected in-memory computation (IMC) processing tiles.

### BACKGROUND

Data communication between in-memory computation (IMC) tiles, for example within a tile cluster, is a critical concern for efficient operation of a neural processing unit (NPU). The data passed between IMC tiles can include feature data, weight data and computation data (such as sum and partial sum, partial product and/or partial compute data).

It is critical to control the timing of IMC tile operations and communications to ensure proper computation and resynchronization of data.

There is accordingly a need in the art for improved clocking of operations to read weight data for an in-memory computation operation by multiple IMC tiles, execute computation operations by shared computation logic on the read weight data, and resynchronize computation output for further processing within the neural processing unit.

### SUMMARY

In an embodiment, the disclosure provides a circuit comprises: a first in-memory computation (IMC) circuit comprising a first IMC processing tile having a processing operation clocked by a first internal clock signal; a second IMC circuit comprising a second IMC processing tile having a processing operation clocked by a second internal clock signal; a shared compute resource circuit having a processing operation clocked by an internal computation clock signal; a shared resource bus connecting the first IMC circuit, second IMC circuit and shared compute resource circuit in support of time multiplexed data communications among and between the first IMC circuit, second IMC circuit and shared compute resource circuit; and a clock gating circuit having an input configured to receive the internal computation clock signal and an output configured to supply the first internal clock signal by selectively gating a first pulse of the internal computation clock signal and supply the second internal clock signal by selectively gating a second pulse of the internal computation clock signal.

In embodiments, the circuit further comprises :
a local clock generator having an input configured to receive a clock signal and an output configured to supply the internal computation clock signal derived from the clock signal; and
a control circuit configured to generate first control signaling input to the local clock generator input to the local clock generator to control the inclusion of the first and second pulses, for the first and second IMC circuits, respectively.

In embodiments, the first and second IMC processing tiles are part of a single stall domain.

In embodiments, the selectively gating performed by the clock gating circuit is controlled by second control signaling generated by the control circuit.

In embodiments, the circuit further comprises a resynchronization circuit having a processing operation clocked by the clock signal, wherein the shared resource bus connects the first IMC circuit, second IMC circuit, shared compute resource circuit and resynchronization circuit in support of time multiplexed data communications among and between the first IMC circuit, second IMC circuit, shared compute resource circuit and resynchronization circuit.

In embodiments, the processing operation of the first IMC processing tile is a reading of weight data from a memory of the first IMC processing tile and outputting of the read weight data for time multiplexed data communications over the shared resource bus to the shared compute resource circuit in response to the first internal clock signal.

In embodiments, the processing operation of the shared compute resource circuit is a processing of the read weight data received from the first IMC processing tile in response to the internal computation clock signal.

In embodiments, the processing operation of the second IMC processing tile is a reading of weight data from a memory of the second IMC processing tile and outputting of the read weight data for time multiplexed data communications over the shared resource bus to the shared compute resource circuit in response to the second internal clock signal.

In embodiments, the processing operation of the shared compute resource circuit is a processing of the read weight data received from the second IMC processing tile in response to the internal computation clock signal.

In embodiments, the processing operation of the first IMC processing tile is an in-memory computation operation based on weight data stored in a memory of the first IMC processing tile and feature data applied to the first IMC processing tile, wherein computation output data is output, for time multiplexed data communications over the shared resource bus, to the shared compute resource circuit in response to the first internal clock signal.

In embodiments, the processing operation of the shared compute resource circuit is a processing of the computation output data received from the first IMC processing tile in response to the internal computation clock signal.

In embodiments, the processing operation of the second IMC processing tile is an in-memory computation operation based on weight data stored in a memory of the second IMC processing tile and feature data applied to the second IMC processing tile, wherein computation output data is output, for time multiplexed data communications over the shared resource bus, to the shared compute resource circuit in response to the second internal clock signal.

In embodiments, the processing operation of the shared compute resource circuit is a processing of the computation output data received from the second IMC processing tile in response to the internal computation clock signal.

In embodiments, the shared compute resource circuit is a part of a third IMC circuit connected to the shared resource bus.

In an embodiment, the disclosure provides a method comprises: receiving a clock signal; generating an internal computation clock signal derived from the clock signal and including a number of pulses within each period of the clock signal equal to a number of in-memory computation (IMC) processing tiles of a tile cluster that are included within a stall domain of a neural processing circuit; selectively gating the pulses of the internal computation clock signal to generate a corresponding plurality of internal clock signals applied to respective ones of the IMC processing tiles of the tile cluster within the stall domain; wherein timing of processing operations performed each IMC processing tile of the tile cluster within the stall domain is controlled by the internal clock signals applied to that IMC processing tile; time multiplexed passing of data communications generated by the processing operations performed by the IMC processing tiles of the tile cluster over a shared resource bus to a shared compute circuit; and processing the data communications by the shared compute circuit in response to the internal computation clock signal.

In embodiments, the method further comprises resynchronizing output of the shared compute circuit in response to the clock signal.

In embodiments, the method further comprises time multiplexed passing of output of the shared compute circuit.

In embodiments, the data communications generated by the processing operation performed by each IMC processing tile comprises reading weight data from a memory of the IMC processing tile for output over the shared resource bus to the shared compute resource circuit in response to the internal clock signal.

In embodiments, processing the data communications by the shared compute circuit comprises processing the read weight data received from the IMC processing tiles.

In embodiments, the data communications generated by the processing operation comprise computation data generated from an in-memory computation operation based on weight data stored in a memory of the IMC processing tile and feature data applied to the IMC processing tile.

In embodiments, processing the data communications by the shared compute circuit comprises processing the computation data received from the IMC processing tiles.

### BRIEF DESCRIPTION OF THE DRAWINGS

For a better understanding of the embodiments, reference will now be made by way of example only to the accompanying figures in which:
Figure 1A is a block diagram of a multi-island in-memory computation (IMC) neural processing unit (NPU);
Figure 1B is a block diagram for an individual IMC NPU island including a plurality of IMC tile clusters;
Figure 1C is a block diagram of an IMC tile cluster including a plurality of in-memory computation (IMC) circuits;
Figure 1D is a block diagram of an embodiment for the IMC circuit;
Figures 2A and 2B are more detailed diagram of the IMC circuit;
Figures 3A and 3B show a functional operation block diagram for the IMC tile cluster;
Figure 3C shows a timing diagram for the clock signals of the IMC tile cluster;
Figure 4 is a circuit diagram for an implementation of a clock generator circuit used to generate an internal clock for an IMC tile; and
Figures 5A and 5B show a schematic diagram of an example implementation for the IMC tile.

### DETAILED DESCRIPTION OF THE DRAWINGS

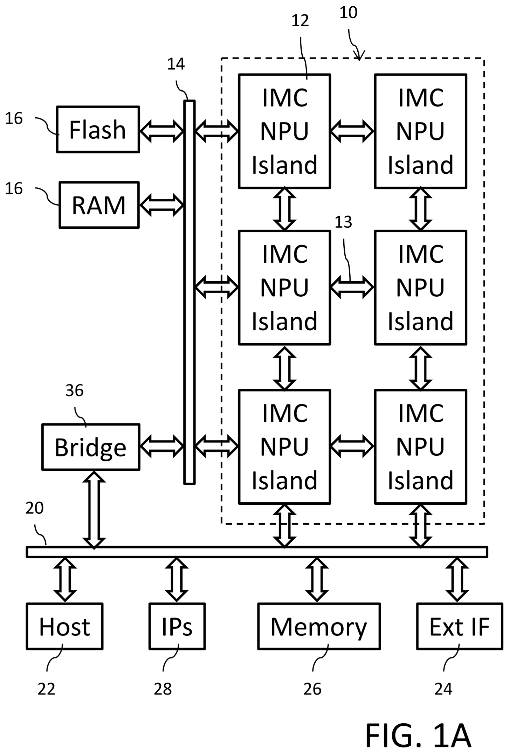

Reference is now made to Figure 1A which shows a processing system block diagram where the system includes a multi-island in-memory computation (IMC) neural processing unit (NPU) 10. The multi-island IMC NPU 10 includes a plurality of IMC NPU islands 12 arranged in an array and interconnected with each other by a data interconnection network 13. The plurality of IMC NPU islands 12 of the multi-island IMC NPU 10 are further connected through a memory bus 14 to memory circuits 16 (comprising, for example, a flash memory, or a random access memory (RAM)). The data stored in the memory circuits 16 include the computational weights of a network. Before the in-memory computation is executed, the weights of a processing layer whose computation is going to be performed are transferred from the memory circuits 16 to an IMC tile (to be discussed in detail below) within a given IMC NPU island 12. The system RAM can also store the sum and partial sum, partial product and/or partial compute outputs coming out of the IMC tiles of the IMC NPU islands 12 which are going to be used in next processing layer computations. The plurality of IMC NPU islands 12 are further coupled through a system bus 20 to a host processing unit 22 and an external interface (IF) circuit 24. The host processing unit 22 (also referred to as the central processing unit (CPU)) is responsible for executing instructions from programs and managing the overall operation of the system. It coordinates the activities of all other hardware components and ensures that tasks are carried out efficiently. A data storage memory 26 is also coupled to the system bus 20 for access by the host processing unit 22. The data storage memory 26 can store programming and application data needed by the host processor. One or more functional (IP) circuits 28 are further connected to the system bus 20. The functional (IP) circuits can be any intellectual property circuit or block which is used in the system. Examples of such include: a direct memory access (DMA) circuit, a serial peripheral interface (SPI) circuit, a universal asynchronous receiver-transmitter (UART) circuit, a universal serial bus (USB) circuit, a clock and reset generator circuit, a top level register interface circuit, data convertor circuits, etc. A data bridge circuit 36 interconnects the system bus 20 and the memory bus 14 in support of data communications therebetween.

To summarize, the Neural Processing Unit (NPU) is an accelerator designed to enhance the performance of neural processing tasks. Within the system, it communicates with various components, including the system and external memory, to retrieve weights and store sums or partial sums, partial products and/or partial computes. Additionally, it interacts with different sensor functional (IP) circuits and memories to obtain input features.

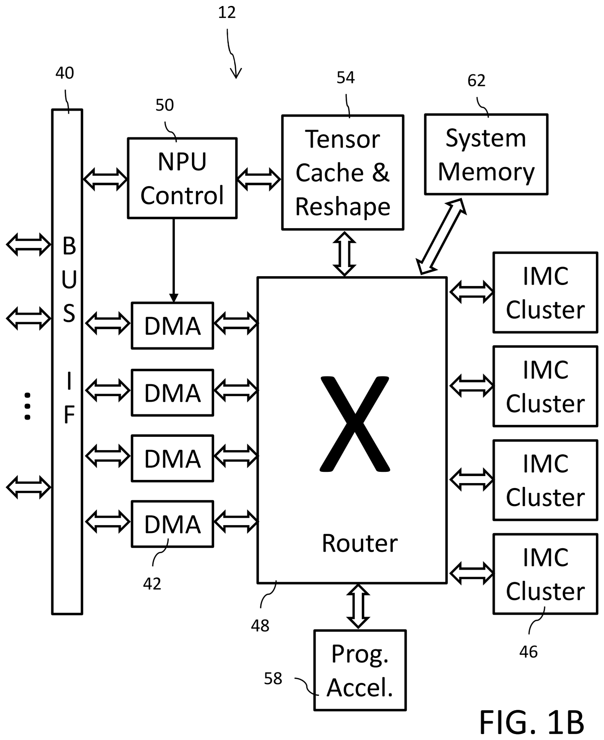

Reference is now made to Figure 1B which shows a block diagram for an individual IMC NPU island 12. Each IMC NPU island 12 includes a bus interface 40 for supporting connection of the island 12 to other islands 12 and also to one or the other or both of the system bus 20 and the memory bus 14. A plurality of direct memory access (DMA) circuits 42 are connected to the bus interface 40. The DMA circuits 42 function as data movers, and operate to move data from one memory to another memory. In this case, the DMA circuits 42 are used to transfer the data from External Flash/Non-Volatile Memory to System memory or System memory to IMC memory and IMC Outputs to System Memory. A plurality of IMC tile clusters 46 are interconnected to the DMA circuits 42 through a local router circuit 48. A control circuit 50 for NPU operations is connected to the bus interface 40 and to the DMA circuits 42. The NPU control circuit 50 controls the different modules of the NPU subsystem. All the NPU programming registers are part of the NPU control. A tensor cache and reshaping circuit 54 is coupled to the local router circuit 48. The tensor cache and reshaping module 54 functions to reshape the input features and weights as required by the IMC tiles for computation. A program accelerator circuit 58 is coupled to the local router circuit 48 and is configured to perform various scalar operations within the NPU. A system non-volatile memory circuit 62 is also coupled to the local router circuit 48. This memory circuit 62 is configured to store weight data for the in-memory computation operations, with this weight data being selectively accessed and delivered through the local router circuit 48 to the IMC tile clusters 46.

To summarize, the IMC NPU island 12 comprises a collection of (for example, one or more) IMC tile clusters 46. This IMC NPU island 12 features a control circuit 50 that manages the NPU, a data reshaping block 54 to adjust input data for the IMC clusters, data movers 42 to facilitate data transfer, and accelerators 58 to perform various scalar operations within the NPU. All these different blocks coordinate and communicate with each other via the local router circuit 48. External data transfer is accommodated through the bus interface 40.

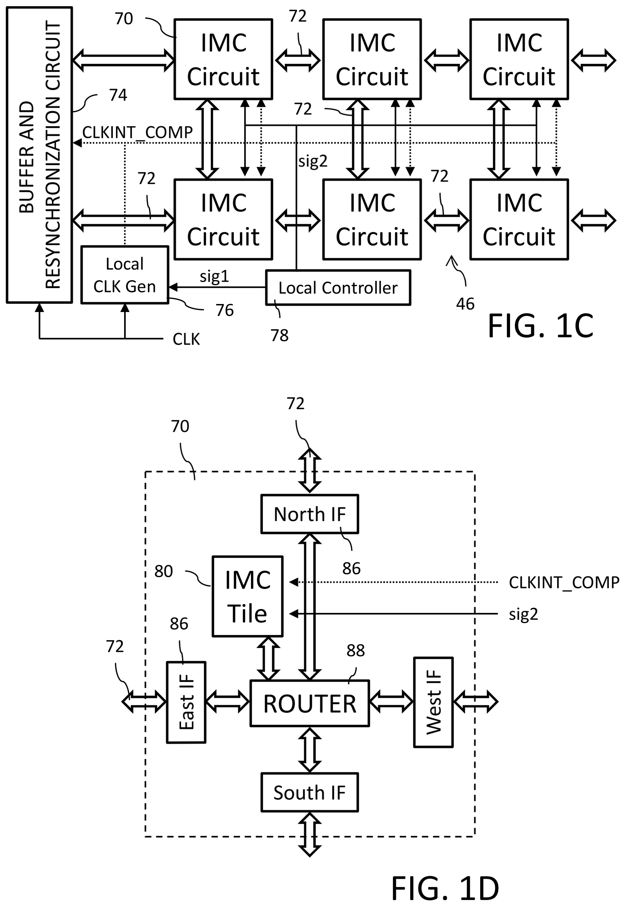

Reference is now made to Figure 1C which shows a block diagram of an IMC tile cluster 46. Each tile cluster 46 includes a plurality of in-memory computation operation (IMC) circuits 70 (for example, implemented as analog IMC (AIMC) circuits or digital IMC (DIMC) circuits) arranged in an array. Adjacent circuits 70 are interconnected for data communication over a shared resource bus 72. The tile cluster 46 is connected to the router 48 of the IMC NPU island 12. The arrangement of the IMC circuits 70 can be programmed depending on processing requirements so that a certain IMC circuit 70 is connected to the router 48 of the IMC NPU island 12. The connection between the tile cluster 46 and the router 48 is facilitated through a buffer and resynchronization circuit 74 which is part of the tile cluster 46. The shared resource bus 72 may be used by the IMC circuits 70 for the purpose of communicating, from one circuit 70 to an adjacent circuit 70, feature data, weight data and/or computation data (such as sum and partial sum, partial product and/or partial compute data).

An advantage of using a shared resource bus 72 is that separate buses or communications links need not be provided to carry different types of data (such as feature data, weight data and/or computation data). There is also support for shared compute resources between two or more IMC circuits 70 using data communicated over the shared resource bus 72. This also facilitates having certain IMC circuits 70 within a given tile cluster 46 be configured to have certain computation logic and/or decompressor logic that is shared for use, in a time-shared manner, by all IMC circuits 70 within the tile cluster 46. The decompressor logic within the certain IMC circuit 70 can be used to process compressed computation weights stored in the processing tile memory to access and output decompressed weight data to other IMC circuits 70 within the tile cluster 46. The presence of structured and unstructured sparsity in both weight data and feature data gives the opportunity of compressing the data and using the processing tiles of the IMC circuits 70 in a dense manner. The inclusion of decompressor logic can be costly, and thus providing a solution where decompressor logic is shared across tiles presents a significant advantage.

The foregoing implementation thus supports a compressed data storage as well as a decompressed computation. Compute resources can be shared by many IMC circuits 70 in sparse mode.

Controlling the clocking of the IMC circuits 70 and the buffer and resynchronization circuit 74 within the tile cluster 46 is critical to ensuring data communication between IMC circuits 70, execution of computation operations by the IMC circuits 70 and the resynchronization of computation results by the buffer and resynchronization circuit 74. Each tile cluster 46 receives a cluster clock signal CLK which is applied to the buffer and resynchronization circuit 74 as well as to a local clock generator circuit 76. The cluster clock signal CLK enables the tile cluster 46 to work asynchronously relative to the collection of tile clusters 46 within the IMC NPU island 12 (see, Figure 1B). The buffer and resynchronization circuit 74 uses the cluster clock signal CLK for ensuring resynchonization with respect to data communications with the IMC circuits 70. The local clock generator circuit 76 generates an internal computation clock signal CLKINT _COMP from the cluster clock signal CLK, with that internal computation clock signal CLKINT _COMP being delivered to each IMC circuit 70 within the tile cluster 46. A local controller circuit 78 for the tile cluster 46 generates control signaling sig1 applied to the local clock generator circuit 76 to control the triggering of the internal computation clock signal CLKINT _COMP and generates control signaling sig2 applied to the IMC circuit 70 to control gating of the internal computation clock signal CLKINT _COMP within each IMC circuit 70 in support of selectively controlled tile operations such as data (for example, weight) read and digital computation based on weight data and feature data.

Although the local clock generator circuit 76 is illustrated in Figure 1C separate from the IMC circuits 70, this illustration is functionally schematic in nature, it being understood that the local clock generator circuit 76 may be separate or contained within one IMC circuit 70 and shared by all DIMC circuits 70 within the tile cluster 46.

The control signaling sig2 can be used to tie a number of IMC circuits 70 within the tile cluster 46 to a single stall domain. In this context, all tiles and control logic which are working on a same clock with linked outputs leading to a final computation output for a given computation operation are considered to be part of the same stall domain. These IMC circuits 70 are grouped together by the gated internal computation clock signal CLKINT _COMP. The number and assignment of the IMC circuits 70 to the stall domain can be dynamically configured through the operation of the local controller circuit 78 based on data flow, NPU control and/or tensor and cache reshaping function.

The IMC tile cluster 46 thus comprises one or more IMC circuits 70. Within a cluster, these IMC circuits 70 can be utilized independently or linked in various configurations to handle any neural network workload (including, without limitation, chaining and parallel processing operations).

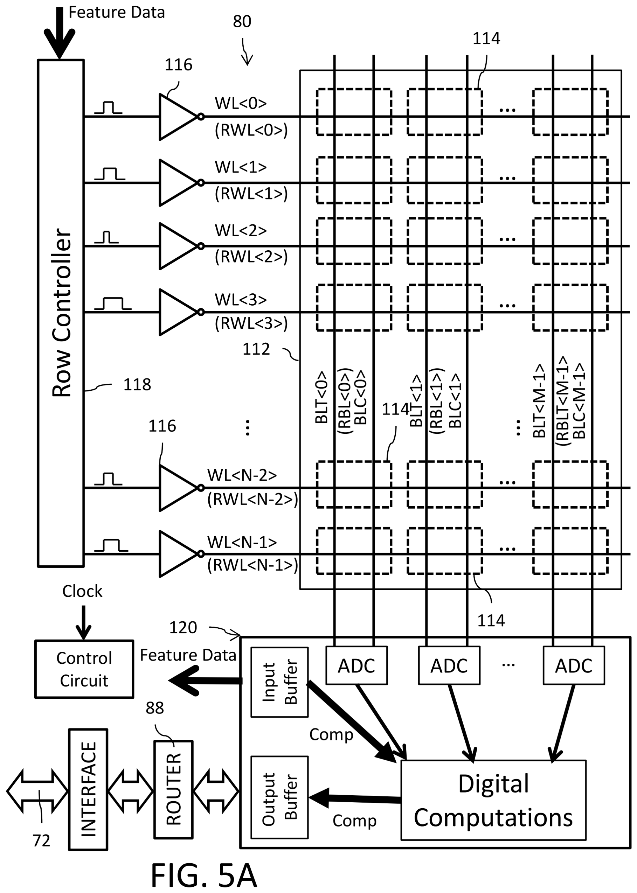

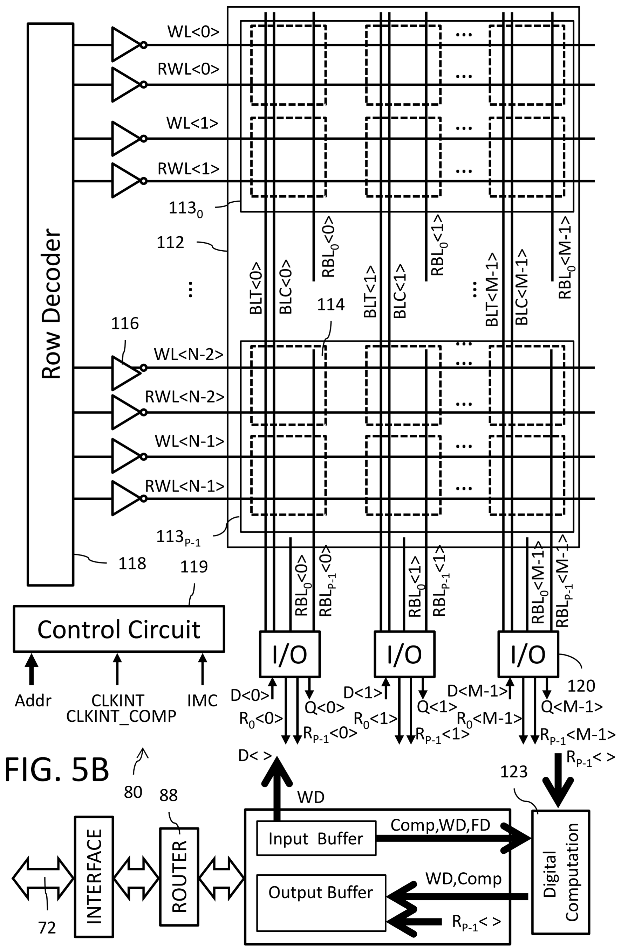

Figure 1D shows a block diagram of an embodiment for the IMC circuit 70. Each IMC circuit 70 includes an IMC processing tile 80 (of analog (i.e., AIMC) or digital (i.e., DIMC) type). The tile 80 is configured for performing an in-memory computation (IMC) operation based on stored weight data and received feature data. An example of such an IMC processing tile configured to support analog processing is shown in United States Patent Application Publication No. 2024/0112728 (incorporated herein by reference; see also an example in Figure 5A). An example of such an IMC processing tile configured to support digital processing is shown in United States Patent Application Publication No. 2024/0071439 (incorporated herein by reference; see also an example in Figure 5B). This IMC processing tile 80 can include computation logic which provides a processing resource that can be shared by the processing tiles 80 of other IMC circuits 70. This IMC processing tile 80 can include decompressor logic which provides a further processing resource relating to decompressing stored weight data that can be shared by the processing tiles 80 of other IMC circuits 70.

The timing of operations performed by the IMC processing tile 80 is dependent on the internal computation clock signal CLKINT_COMP. A gating circuit (to be described in more detail below) receives the internal computation clock signal CLKINT _COMP as well as the control signaling sig2. The gating circuit controls gating of the internal computation clock signal CLKINT _COMP based on the control signaling sig2 for clocking operations performed by circuitry of the IMC processing tile 80 such as: reading of weight data, performance of in-memory computations and communication of data, such as read weight data and/or calculated computation data (such as sum and partial sum, partial product and/or partial compute data), over the shared resource bus 72.

Each IMC circuit 70 is coupled to the shared resource bus 72 through an interface circuit (IF) 86 for engaging in data communications with an adjacent IMC circuit 70 (through its corresponding interface circuit 86). In the example arrayed configuration of the tile cluster 46, there is an interface circuit 86 associated with each Cardinal compass direction (north, south, east, west). The IMC processing tile 80 for that IMC circuit 70 is coupled for data communication to a given one of the interface circuits 86 through a router circuit 88. In an example embodiment, the router circuit 88 may be implemented using a packet switched network or a circuit switched network.

Each IMC processing tile 80 is coupled to the router circuit 88 to receive feature data of the in-memory computation operation being performed. That feature data may, for example, be communicated to the IMC processing tile 80 via the router 48 of the IMC NPU island 12 over the shared resource buses 72 which interconnect IMC processing tiles 80 and the router 88. Each IMC processing tile 80 is also coupled to the router circuit 88 to receive weight data of the in-memory computation operation being performed. That weight data may, for example, be communicated to the IMC processing tile 80 via the router 48 of the IMC NPU island 12 (for example, being retrieved from the ePCM memory 62) over the shared resource buses 72 which interconnect IMC processing tiles 80 and the router 88. The IMC processing tile 80 may also be a source of weight data (compressed or uncompressed) that is read from the tile and communicated via the router circuit 88 for transmission over the shared resource buses 72 to other IMC processing tiles 80. Additionally, each IMC processing tile 80 is coupled to the router circuit 88 to output processing data (for example, sum and partial sum, partial product and/or partial compute outputs) of the in-memory computation operation being performed. That processing data may, for example, be communication from the IMC processing tile 80 over the shared resource buses 72 which interconnect IMC processing tiles 80 and the router 88. The IMC processing tile 80 may further receive input processing data (for example, sum and partial sum, partial product and/or partial compute outputs) of the in-memory computation operation being performed from other IMC processing tiles 80 via the router circuit 88 as transmitted over the shared resource buses 72.

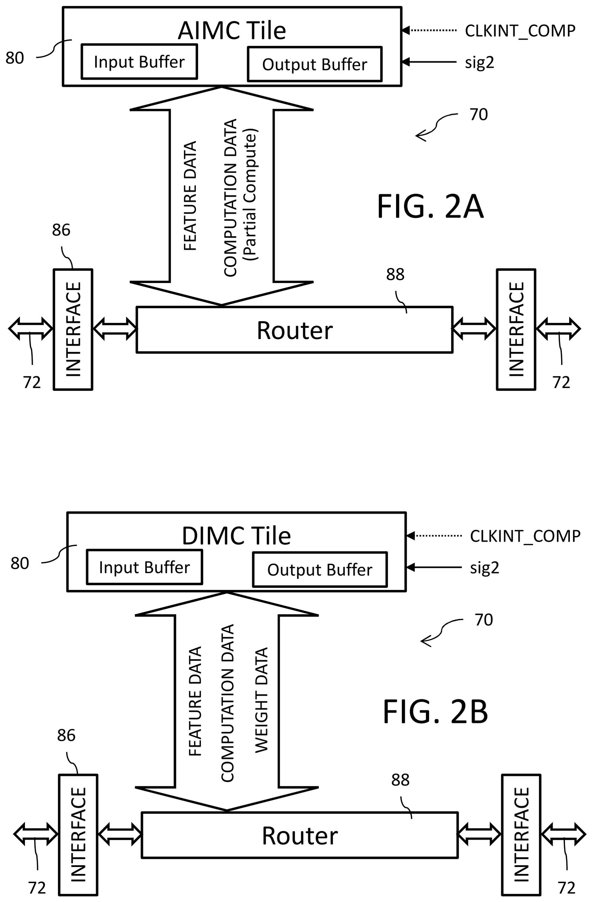

Reference is now made to Figures 2A and 2B which show a more detailed block diagram of the IMC circuit 70 (of analog IMC type in Figure 2A and of digital IMC type in Figure 2B).

The IMC processing tile 80 includes data buffer circuits configured to buffer data with respect to communication through the router 88 and over the shared resource bus 72. Input buffer circuits can hold weight data, feature data and/or computation data which has been received over the shared resource bus 72 through the interface 86 and routed by router 88 to the IMC processing tile 80. Output buffer circuits can hold weight data, feature data and/or computation data generated by the IMC processing tile 80 to be routed by the router 88 and transmitted through the interface 86 over the shared resource bus 72.

This allows feature data, for example, to be broadcast over the shared resource bus 72 for input to the IMC processing tiles 80 of multiple IMC circuits 70. This is important, for example, in support of in-memory computation operations where the same feature data is applied in the computation against different sets of weight data stored in different IMC circuits 70. Control signaling can be used to specifically select the IMC processing tiles 80 of the multiple IMC circuits 70 which are to receive the feature data to be an operating mode to access the shared resource bus 72 and use their input buffer circuits, functioning as feature buffers, to receive the broadcast feature data. In an alternative implementation, the feature data may pass from the shared resource bus 72 directly for use by the IMC processing tile 80 without need for handing by a buffer circuit.

This also allows weight data to be read from the IMC processing tile 80 of one IMC circuit 70 and communicated to the IMC processing tiles 80 of multiple IMC circuits 70. Control signaling can be used to specifically select the source IMC processing tile 80 of one IMC circuit 70 providing the weight data to be in an operating mode where the output buffer circuit, functioning as a weight buffer, outputs the weight data to the shared resource bus 72 and specifically select the destination IMC processing tile(s) 80 of IMC circuit(s) 70 receiving the weight data to be in an operating mode where their input buffer circuits, functioning as weight buffers, receives the transmitted weight data. In an alternative implementation, the weight data may pass from the shared resource bus 72 directly for use by the IMC processing tile 80 without need for handing by a buffer circuit.

This further allows computation data generated by the in-memory computation operation performed by the IMC processing tile 80 of one IMC circuit 70 to be communicated for further processing by the IMC processing tile 80 of another IMC circuit 70. Control signaling can be used to specifically select the source IMC processing tile 80 of one IMC circuit 70 providing the computation data to be an operating mode where the output buffer circuit, functioning as a partial sum or partial product buffer, outputs the computation data to the shared resource bus 72 and specifically select the destination IMC processing tile(s) 80 of IMC circuit(s) 70 receiving the computation data to be an operating mode where their input buffer circuits, functioning as partial sum or partial product buffers, receives the transmitted computation data. In an alternative implementation, the computation data may pass from the shared resource bus 72 directly for use by the IMC processing tile 80 without need for handing by a buffer circuit.

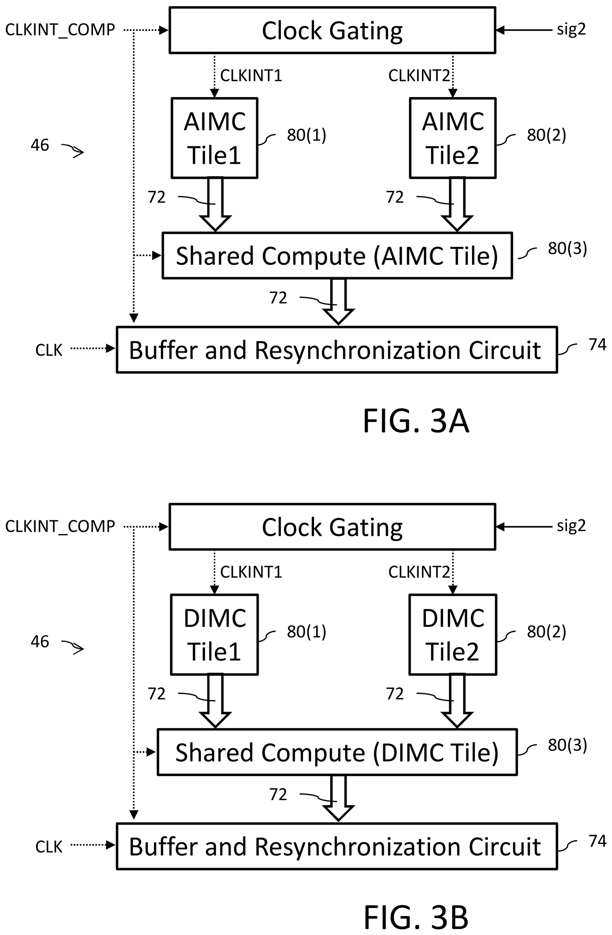

Reference is now made to Figures 3A and 3B which show a functional operation block diagram (simplified) for the IMC tile cluster 46 (of analog IMC type in Figure 3A and of digital IMC type in Figure 3B). Two IMC tiles 80(1) and 80(2), each part of an IMC circuit 70, are part of a stall domain. A clock gating circuit receives the internal computation clock signal CLKINT _COMP (generated by the local clock generator circuit 76 from the cluster clock signal CLK as shown in Figure 1C) and receives the control signaling sig2 (generated by the local controller circuit 78 as shown in Figure 1C). The first IMC tile 80(1) is configured to perform a first in-memory computation operation, and the timing of execution of that operation is controlled by a first internal clock signal CLKINT1 that is derived from the internal computation clock signal CLKINT _COMP through a selective gating operation controlled by the control signaling sig2. The result of the computation by the first IMC tile 80(1) is output from the output buffer, through router 88 and interface 86, over the shared resource bus 72. The second IMC tile 80(2) is configured to perform a second in-memory computation operation, and the timing of execution of that operation is controlled by a second internal clock signal CLKINT2 that is derived from the internal computation clock signal CLKINT _COMP through a selective gating operation controlled by the control signaling sig2. The result of the computation by the second IMC tile 80(2) is output from the output buffer, through router 88 and interface 86, over the shared resource bus 72. The computation results from the first and second DIMC tiles 80(1) and 80(2) are received by a shared compute circuit from the shared resource bus 72. This shared compute circuit may, for example, be the computation functionality provided by third IMC tile 80(3) within the IMC tile cluster 46. The shared compute circuit is configured to perform a computation operation on the computation results from the first and second IMC tiles 80(1) and 80(2), and the timing of execution of that operation is controlled by the internal computation clock signal CLKINT _COMP. The result of the computation by the shared compute circuit (of IMC tile 80(3)) is output from the output buffer, through router 88 and interface 86, over the shared resource bus 72 to the buffer and resynchronization circuit 74. Storage and resynchronization of the data from the shared compute circuit is dependent on timing provided by the cluster clock signal CLK. In the instance of an implementation with AIMC tiles 80, the shared compute circuit can function for the merging of signal lines (such as BLT, BLC, RBL (see, Figure 5A)) across multiple tiles and/or the sharing of ADC processing resources across multiple tiles with or without the merging of compute lines.

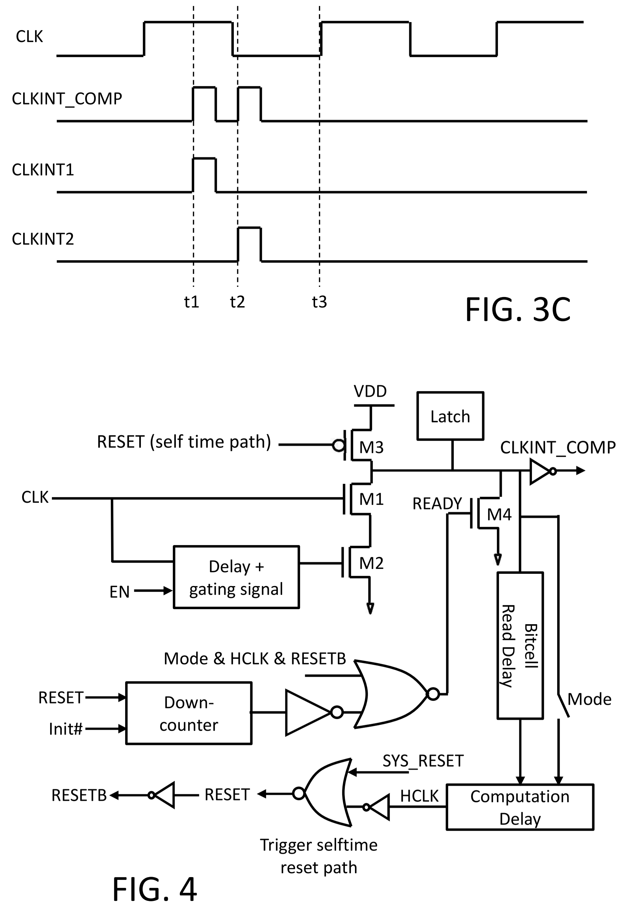

Reference is now made to Figure 3C which shows a timing diagram for the clock signals of the IMC tile cluster. The local clock generator circuit 76 receives the cluster clock signal CLK and the control signaling sig1 from the local controller circuit 78 to control the triggering of the internal computation clock signal CLKINT _COMP at times t1 and t2. The generation of two pulses for the internal computation clock signal CLKINT _COMP at times t1 and t2 within one period of the cluster clock signal CLK is dependent on the control signaling sig1 from the local clock generator circuit 76 indicating that two IMC tiles 80(1) and 80(2) are tied to a single stall domain. The setting of a counter circuit with an initial count value (int#) as discussed below is used to set the number of pulses for the internal computation clock signal CLKINT _COMP within one period of the cluster clock signal CLK.

The clock gating circuit selectively gates the internal computation clock signal CLKINT _COMP at time t1 to pass the first clock pulse as the first internal clock signal CLKINT1 to the first IMC tile 80(1). The first IMC tile 80(1) performs its in-memory computation operation in response to the first clock pulse gated through the first internal clock signal CLKINT1 and a result of the computation is passed over the shared resource bus 72 to the shared compute circuit. The result of the computation may comprise a read of weight data from the memory of the first IMC tile 80(1), forming a weight vector for example, to be passed over the shared resource bus 72 for further processing within the IMC tile cluster 46. Alternatively, the result of the computation may comprise the result (for example, a sum and partial sum, partial product and/or partial compute) output produced by a computation circuit of the first IMC tile 80(1) to be passed over the shared resource bus 72 for further processing within the IMC tile cluster 46.

The shared compute circuit is clocked by the internal computation clock signal CLKINT _COMP and receives the first pulse at time t1. In response thereto, the shared compute circuit performs a computation operation as a function of the computation result provided by the first IMC tile 80(1).

The shared resource bus 72 and the shared compute circuit are thus shared by time multiplexing for access by the first IMC tile 80(1) through the gated first clock pulse of the internal computation clock signal CLKINT _COMP.

The clock gating circuit then selectively gates the internal computation clock signal CLKINT _COMP at time t2 to pass the second clock pulse as the second internal clock signal CLKINT2 to the second IMC tile 80(2). The second IMC tile 80(2) performs its in-memory computation operation in response to the second clock pulse gated through the second internal clock signal CLKINT2 and a result of the computation is passed over the shared resource bus 72 to the shared compute circuit. Here again, the result of the computation may comprise a read of weight data from the memory of the second IMC tile 80(2), forming a weight vector for example, to be passed over the shared resource bus 72 for further processing within the IMC tile cluster 46. Alternatively, the result of the computation may comprise the result (for example, a sum and partial sum, partial product and/or partial compute) output produced by a computation circuit of the second IMC tile 80(2) to be passed over the shared resource bus 72 for further processing within the IMC tile cluster 46.

The shared compute circuit is clocked by the internal computation clock signal CLKINT _COMP and receives the second pulse at time t2. In response thereto, the shared compute circuit performs a computation operation as a function of the computation result provided by the second IMC tile 80(2), and perhaps also as a function of the computation result provided by the first IMC tile 80(1).

The shared resource bus 72 and the shared compute circuit are thus shared by time multiplexing for access by the second IMC tile 80(2) through the gated second clock pulse of the internal computation clock signal CLKINT_COMP.

At time t3, a next cycle of the cluster clock signal CLK begins. The buffer and resynchronization circuit 74 receives both the cluster clock signal CLK and internal computation clock signal CLKINT_COMP and responds thereto at time t3 by receiving the computation result from the shared compute circuit over the shared resource bus 72, by time multiplexing, in order to store and resynchronize the computation data.

As noted above, the router circuit 88 may be implemented using a packet switched network or a circuit switched network. In a packet switched network implementation, the data to be communicated over the shared resource bus 72 are multiplexed as data packets on the shared resource bus 72 at different time intervals responsive to the gated internal clock signal CLKINT derived from the internal computation clock signal CLKINT _COMP. Control logic specifies packet access at a given time interval for the data communication. In a circuit switched network, tristate buffers drive the signal lines of the shared resource bus 72 at different time intervals within a system clock period responsive to the gated internal clock signal CLKINT derived from the internal computation clock signal CLKINT _COMP. Control logic circuit specifies access at a given time interval for the data communication.

Reference is now made to Figure 4 which shows a circuit diagram for an implementation of a clock generator circuit (for example for clock generator circuit 76) used to generate an internal clock for use by the processing tiles. The received clock signal CLK is applied to the gate of n-channel MOSFET M1 and to the input of a Delay and Gating Signal circuit that is enabled to pass the signal CLK in response to an enable and gating control signal EN. The output of the Delay and Gating Signal circuit is applied to the gate of n-channel MOSFET M2. The transistors M1 and M2 have their source-drain paths connected in series between the output node for internal clock signal CLKINT _COMP and ground. A p-channel MOSFET M3 has its source-drain path coupled between the supply node VDD and the output node for internal clock signal intCLK. The gate of transistor M3 receives a selftime path reset signal (RESET). The logic state of the internal clock signal CLKINT _COMP is latched by a latch circuit.

The output internal clock signal CLKINT _COMP is further applied to the input of a Bitcell Read Delay circuit that applies a delay corresponding to a delay required to access the memory (this delay being bitcell dependent). This delay corresponds to weight (kernel) access which reside in the memory. The output of the Bitcell Read Delay circuit is applied to the input of a Computation Delay circuit that applies a delay which tracks the computation delay (for example, multiplication, XOR, XNOR, etc.) of the in-memory computation operation. Dependent on operation mode, as indicated by the logic state of the mode signal (Mode), the Bitcell Read Delay circuit is selectively bypassed using a bypass switching circuit. Since weight access is performed associated with the first internal clock cycle, the delay is needed only for that first internal clock cycle and the bypass is actuated for the second (and any following) clock cycles. If the mode of operation is only computation, then the bypass pass is actuated to selectively bypass the Bitcell Read Delay circuit. The output from the Computation Delay circuit provides a further clock signal HCLK from which the selftime path reset signal RESET is generated using logic circuitry formed by a logic inverter (NOT gate) and a logic NOR gate which receives the clock signal HCLK and the system reset (SYS_RESET) signal. The selftime path reset signal RESET is output from the logic NOR gate.

A down-counter circuit is loaded with an initial count value (init#) and is configured to count down from the initial count value in response to pulses of the reset signal RESET. The initial count value (init#) is set equal to the number of pulses to be included in the internal clock signal CLKINT _COMP for each cycle of the clock signal CLK. If the current count value in the down-counter circuit is not zero, the output of the counter has a first logic state (for example, logic 1). When the count down is completed and the current count value in the down-counter circuit is zero, the output of the counter has a second logic state (for example, logic 0). The output of the down-counter circuit is applied to one input of a logic NOR gate. The second input of the logic NOR gate receives a control signal derived from a mode control signal Mode, the further clock signal HCLK and the logical inverse (RESETB) of the reset signal RESET. The output of the logic NOR gate, the signal READY, is applied to the gate of n-channel MOSFET M4. The source-drain path of transistor M4 is connected between the output node for internal clock signal CLKINT _COMP and ground. A logic NOT gate inverts the latched signal for output. The signals CLKINT, CLKINT2, etc. are generated by selective gating of the pulses (set by the initial count value (init#)) within the internal clock signal CLKINT _COMP.

Reference is now made to Figure 5A which shows a schematic diagram of an example implementation for the AIMC processing tile 80. See, also, United States Patent Application Publication No. 2024/0112728 incorporated herein by reference for further examples of AIMC processing tile 80 configurations. The AIMC processing tile 80 utilizes a memory circuit including an array 112 of the memory cells 114 (for example, a static random access memory (SRAM) array formed by standard 6T SRAM memory cells) arranged in a matrix format having N rows and M columns. As an alternative, a standard 8T memory cell or an SRAM or another type of bitcell with a similar functionality and topology could instead be used. Each memory cell 114 is programmed to store a bit of a computational weight or kernel data for an in-memory compute operation. In this context, the in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of the computational weight has either a logic "1" or a logic "0" value.

Each memory cell 114 includes a word line WL and a pair of complementary bit lines BLT and BLC. The 8T-type SRAM cell would additionally include a read word line RWL and a read bit line RBL. The cells 114 in a common row of the matrix are connected to each other through a common word line WL (and through the common read word line RWL in the 8T-type implementation). The cells 114 in a common column of the matrix are connected to each other through a common pair of complementary bit lines BLT and BLC (and through the common read bit line RBL in the 8T-type implementation). Each word line WL, RWL is driven by a word line driver circuit 116 which may be implemented as a CMOS driver circuit (for example, a series connected p-channel and n-channel MOSFET transistor pair forming a logic inverter circuit). The word line signals applied to the word lines, and driven by the word line driver circuits 116, are generated from feature data input to the tile 80 and controlled by a row controller circuit 118. A column processing circuit 120 senses the analog signals on the pairs of complementary bit lines BLT and BLC (and/or on the read bit line RBL) for the M columns, converts the analog signals to digital signals, performs digital calculations on the digital signals and generates a computation data output (for example, computation data or partial compute data) for the in-memory compute operation (passed, for example, through an output buffer). The digital calculations may further be performed on a computation data input (for example, computation data or partial compute data) for the in-memory compute operation (received, for example, through an input buffer).

Although not explicitly shown in Figure 5A, it will be understood that the tile 80 further includes conventional row decode, column decode, and read-write circuits known to those skilled in the art for use in connection with writing bits of data (for example, the computational weight data) to, and reading bits of data from, the SRAM cells 114 of the memory array 112. This operation is referred to as a conventional memory access mode and is distinguished from the analog in-memory compute operation discussed above.

Each SRAM memory cell 114 may comprise a 6T-type memory cell. The cell 114 may comprise two cross-coupled CMOS inverters whose inputs and outputs are coupled to form a latch circuit having a true data storage node and a complement data storage node which store complementary logic states of the stored data bit. The cell 114 further includes two transfer (passgate) transistors whose gate terminals are driven by a word line WL and whose source-drain paths couple between the true data storage node and a node associated with a true bit line BLT and coupled between the complement data storage node and a node associated with a complement bit line BLC.

Alternatively, each SRAM memory cell 114 may comprise an 8T-type memory cell. The cell 114 may comprise two cross-coupled CMOS inverters whose inputs and outputs are coupled to form a latch circuit having a true data storage node and a complement data storage node which store complementary logic states of the stored data bit. The cell 114 further includes two transfer (passgate) transistors whose gate terminals are driven by a word line WL and whose source-drain paths couple between the true data storage node and a node associated with a true bit line BLT and coupled between the complement data storage node and a node associated with a complement bit line BLC. A signal path between the read bit line RBL and a reference voltage reference forms a read circuit with a read transistor that is gate controlled by the signal at the complement storage node QC and selected by a read word line RWL.

The word line driver circuits 116 are typically coupled to receive the high supply voltage (Vdd) at the high supply node and are referenced to the low supply voltage (Gnd) at the low supply node.

The row controller circuit 118 receives the feature data for the in-memory compute operation (for example, through the input buffer) and in response thereto performs the function of selecting which ones of the word lines WL<0> to WL<N-1> (or read word lines RWL<0> to RWL<N-1>) are to be simultaneously accessed (or actuated) in parallel during an analog in-memory compute operation, and further functions to control application of pulsed signals to the word lines in accordance with that in-memory compute operation. Figure 5A illustrates, by way of example only, the simultaneous actuation of all N word lines with the pulsed word line signals, it being understood that in-memory compute operations may instead utilize a simultaneous actuation of fewer than all rows of the SRAM array. The analog signals on a given pair of complementary bit lines BLT and BLC (or analog signal on the read bit line RBL in the 8T-type implementation) are dependent on the logic state of the bits of the computational weight stored in the memory cells 114 of the corresponding column and the width(s) of the pulsed word line signals applied to those memory cells 114.

The implementation illustrated in Figure 5A shows an example in the form of a pulse width modulation (PWM) for the applied word line signals for the in-memory compute operation dependent on the received feature data. The use of PWM or period pulse modulation (PTM) for the applied word line signals is a common technique used for the in-memory compute operation based on the linearity of the vector for the multiply-accumulation (MAC) operation. The pulsed word line signal format can be further evolved as an encoded pulse train to manage block sparsity of the feature data of the in-memory compute operation. It is accordingly recognized that an arbitrary set of encoding schemes for the applied word line signals can be used when simultaneously driving multiple word lines. Furthermore, in a simpler implementation, it will be understood that all applied word line signals in the simultaneous actuation may instead have a same pulse width.

The input/output buffer circuits support data interconnection of the AIMC processing tile 80 to the shared resource bus 72 through the router 88 of the AIMC circuit 70. The shared resource bus 72 enables transmission of feature data to the AIMC processing tile 80 of a given AIMC circuit 70 (through the input buffer circuit) where that feature data may be applied to the row controller circuit 118 in connection with selecting which ones of the word lines WL are to be actuated and controlling generation of the pulsed word line signals. The shared resource bus 72 further enables transmission of input computation data or partial compute data (Comp) to the AIMC processing tile 80 (through the input buffer circuit) where that computation data is passed to the digital computation logic 123 for use in performing an in-memory computation operation. The AIMC processing tile 80 of a given AIMC circuit 70 may further use the shared resource bus 72 in support of the transmission of output computation data or partial compute data (Comp) from the AIMC processing tile 80 (through the output buffer circuit) to another AIMC circuit 70.

A control circuit of the AIMC processing tile 80 receives the clock signal for timing operations of the DIMC processing tile 80. For example, the clock signal may comprise the internal computation clock signal CLKINT _COMP and/or the internal clock signal CLKINT in connection with controlling timing of operations (read, computation, input, output, etc.) as discussed above in connection with Figure 3A.

Reference is now made to Figure 5B which shows a schematic diagram of an example implementation for the DIMC processing tile 80. See, also, United States Patent Application Publication No. 2024/0071439 incorporated herein by reference for further examples of DIMC processing tile 80 configurations. The DIMC processing tile 80 is implemented using a memory circuit which includes a static random access memory (SRAM) array 112 formed by a plurality of SRAM memory cells 114 arranged in a matrix format having N rows and M columns. Each memory cell 114 is programmed to store a bit of data. In digital in-memory computation processing, the stored data in the memory array 112 comprises computational weight or kernel data for a digital in-memory compute operation. In this context, the digital in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of data stored in the memory array, whether user data or weight data, has either a logic "1" or a logic "0" value.

Each SRAM memory cell 114 may comprise a 6T-type memory cell. The cell 114 may comprise two cross-coupled CMOS inverters whose inputs and outputs are coupled to form a latch circuit having a true data storage node and a complement data storage node which store complementary logic states of the stored data bit. The cell 114 further includes two transfer (passgate) transistors whose gate terminals are driven by a word line WL and whose source-drain paths couple between the true data storage node and a node associated with a true bit line BLT and coupled between the complement data storage node and a node associated with a complement bit line BLC.

Alternatively, each SRAM memory cell 114 may comprise an 8T-type memory cell. The cell 114 may comprise two cross-coupled CMOS inverters whose inputs and outputs are coupled to form a latch circuit having a true data storage node and a complement data storage node which store complementary logic states of the stored data bit. The cell 114 further includes two transfer (passgate) transistors whose gate terminals are driven by a word line WL and whose source-drain paths couple between the true data storage node and a node associated with a true bit line BLT and coupled between the complement data storage node and a node associated with a complement bit line BLC. A signal path between the read bit line RBL and a reference voltage reference forms a read circuit with a read transistor that is gate controlled by the signal at the complement storage node QC and selected by a read word line RWL.

It will be understood that the DIMC processing tile 80 may instead use a different type of memory cell, for example, any form of a bit cell, storage element or synaptic element producing a deterministic readout arranged in an array. As a non-limiting example, consideration is made for the use of a non-volatile memory (NVM) cell such as, for example, magnetoresistive RAM (MRAM) cell, Flash memory cell, phase change memory (PCM) cell or resistive RAM (RRAM) cell). In the following discussion, focus is made on the implementation using an 8T-type SRAM cell 114, but this is done by way of a non-limiting example, understanding that any suitable memory element could be used (e.g., a binary (two level) storage element or an m-ary (multi-level) storage element).

Each cell 114 includes a word line WL, a pair of complementary bit lines BLT and BLC, a read word line RWL and a read bit line RBL. The SRAM memory cells in a common row of the matrix are connected to each other through a common word line WL and through a common read word line RWL. Each of the word lines (WL and/or RWL) is driven by a word line driver circuit 116 with a word line signal generated by a row decoder circuit 118 during read and write operations. The SRAM memory cells in a common column of the matrix across the whole array 112 are connected to each other through a common pair of complementary (write) bit lines BLT and BLC. The array 112 is segmented into P sub-arrays 113₀ to 113_{P-1}. Each sub-array 113 includes M columns and N/P rows of memory cells 114. The SRAM memory cells in a common column of each sub-array 113 are connected to each other through a local read bit line RBL.

The P local read bit lines RBL₀<x> to RBL_{P-1}<x> from the sub-arrays 113 for the column x in the array 112 are coupled, along with the common pair of complementary bit lines BLT<x> and BLC<x> for the column x in the array 112, to a column input/output (I/O) circuit 120(x). Here, x= 0 to M-1. A data input port (D) of the column I/O circuit 120 receives input data (user or weight data) from an input buffer circuit. This received input data is to be written to an SRAM memory cell 114 in the column through the pair of complementary bit lines BLT, BLC in response to assertion of a word line signal in a conventional memory access mode of operation. A data output port (Q) of the column I/O circuit 120 generates output data for storage in an output buffer circuit. This output data is read from an SRAM memory cell 114 in the column through the read bit line RBL in response to assertion of a read word line signal in the conventional memory access mode of operation. Additionally, the column I/O circuit 120 further includes P sub-array data output ports R₀ to R_{P-1} to generate output data. This output data is read from a memory cell 114 on the local read bit line RBL of the corresponding sub-array 113₀ to 113_{P-1}, respectively, in response to the simultaneous assertion of a plurality of read word line signals (one per sub-array 113) in a digital in-memory compute mode of operation. The read output data from the sub-array data output ports R may be stored in the output buffer circuit (for example, as a weight vector). A digital computation processing circuit 123 performs digital computations on the output data from the sub-array data output ports R as a function of feature data. The feature data is received by the digital computation processing circuit 123 from the input buffer circuit. Additionally, or alternatively, the digital computation processing circuit 123 may receive input computation data from the input buffer circuit (this received computation data may, for example, relate to a sum and partial sum, partial product and/or partial compute performed by some other DIMC processing tile 80 in a pipelined processing operation). The digital computation processing circuit 123 functions to generate output computation data for the digital in-memory compute operation. This output computation data is stored in the output buffer circuit (and may, for example, relate to a sum and partial sum, partial product and/or partial compute to be further processed some other DIMC processing tile 80 in a pipelined processing operation).

The processing circuit 123 can implement computation logic for the digital signal processing in a number of ways including: full support of Boolean operations (XOR, XNOR, NAND, NOR, etc.) and vector operations depending on system and application needs; accumulation pipeline operations where vector multiplication is supported within the memory; and matrix vector multiplication pipeline operations where output from the memory as one vector for the multiply and accumulate (MAC) function. The processing circuit 123 can further function to perform decompression operations (for example, for the purpose of decompressing compressed weight data read from the memory 112. It will be noted that the processing circuit 123 is an integral part of the digital in-memory computation circuit 80.

The input/output buffer circuits support data interconnection of the DIMC processing tile 80 to the shared resource bus 72 through the router 88 of the DIMC circuit 70. The shared resource bus 72 enables transmission of weight data (WD) to the DIMC processing tile 80 of a given DIMC circuit 70 (through the input buffer circuit) where that weight data may be written through the D port in a data write mode to the memory 112 or passed to the digital computation logic 123 for use in performing an in-memory computation operation. The DIMC processing tile 80 of a given DIMC circuit 70 may further use the shared resource bus 72 in support of the transmission of weight data read from the memory 112 (through the output buffer circuit) to another DIMC circuit 70 (noting here that the read weight data may be sourced directly from the R< > ports for transmission or pass first through the digital computation logic 123 before transmission). The shared resource bus 72 also enables transmission of feature data (FD) to the DIMC processing tile 80 of a given DIMC circuit 70 (through the input buffer circuit) where that feature data is passed to the digital computation logic 123 for use in performing an in-memory computation operation. The shared resource bus 72 further enables transmission of input computation data (Comp) to the DIMC processing tile 80 (through the input buffer circuit) where that input computation data is passed to the digital computation logic 123 for use in performing an in-memory computation operation. The DIMC processing tile 80 of a given DIMC circuit 70 may further use the shared resource bus 72 in support of the transmission of output computation data (Comp) from the DIMC processing tile 80 (through the output buffer circuit) to another DIMC circuit 70.

The computation logic for the digital signal processing performed by processing circuit 123 is closely integrated with the input/output circuits and the sub-array data output ports R₀ to R_{P-1} to support utilization of a wide (for example, P times) vector access. There are a number of figure of merit (FOM) benefits which accrue from this solution including: enabling multi-word access in a same cycle amortizes the common logic toggling power inside the SRAM when wide vector access occurs; the use of sub-arrays 113 can reduce bit line toggling power consumption (i.e., where P word lines are asserted in parallel to access P corresponding sub-arrays); support of both, with the opportunity to toggle between, the conventional memory access mode of operation and the digital in-memory compute mode of operation; and on/off current ratio on the same bitline improves which is a key concern when the circuitry is implemented using fully-depleted silicon-on-insulator (FDSOI) technology where forward body bias is aggressively used.

It will be noted that the DIMC processing tile 80 presents a conventional SRAM interface through the data input ports D and the data output ports Q in accordance with the conventional memory access mode of operation. In response to an applied memory address (Addr), the circuit supports read (via data output ports Q) and write (via data input ports D) access to a single row of memory cells 114 in the array 112 by the selected assertion of a single word line WL or RWL. The circuit further presents a sub-array processing interface through the sub-array data output ports R₀ to R_{P-1} in accordance with the digital in-memory compute mode of operation. In response to an applied memory address (Addr), the circuit supports simultaneous read (via data output ports R₀ to R_{P-1}) access to a single row of memory cells 114 in each of the sub-arrays 113₀ to 113_{P-1} by the simultaneous assertion of corresponding read word lines RWL. A single address can be decoded to select the plural word lines (one per sub-array 113) for assertion, or plural addresses can be decoded to select the plural word lines (one per sub-array 113) for assertion. The use plural sub-arrays 113 in this mode enables parallelism supporting very wide access for computation processing without sacrificing density. Advantageously, this digital in-memory compute mode of operation utilizes the resources of the conventional SRAM design with modified control, decoding and input/output circuits (as will be discussed herein in detail) to enable parallel access in the digital in-memory compute mode of operation with additional control to toggle between the conventional memory access mode of operation and the digital in-memory compute mode of operation as needed by the system application. This architecture brings parallelism with usage of the push rule bitcell thus enabling high density/compute density when configured for the in-memory compute mode of operation. Notwithstanding the foregoing, as noted above, usage of other bitcell types may instead be made.

A control circuit 119 controls mode operations of the circuitry within the DIMC processing tile 80 responsive to the logic state of a control signal IMC. When the control signal IMC is in a first logic state (for example, logic low), the circuit 80 operates in accordance with the conventional memory access mode of operation (for writing data from data input port D to the memory array or reading data from the memory array to data output port Q). Conversely, when the control signal IMC is in a second logic state (for example, logic high), the DIMC processing tile 80 operates in accordance with the digital in-memory compute mode of operation (for reading weight data from the memory array to the sub-array data output ports R).

The control circuit further receives the clock signal for timing operations of the DIMC processing tile 80. For example, the clock signal may comprise the internal computation clock signal CLKINT _COMP and/or the internal clock signal CLKINT in connection with controlling timing of operations (read, computation, input, output, etc.) as discussed above in connection with Figure 3B.

When the DIMC processing tile 80 is operating in the conventional memory access mode of operation, the row decoder circuit 118 decodes a received address (Addr), selectively actuates only one word line WL (during write) or one read word line RWL (during read) for the whole array 112 with a word line signal pulse to access a corresponding single one of the rows of memory cells 114. In write, logic states of the data at the input ports D are written by the column I/O circuits 120 through the pairs of complementary bit lines BLT, BLC to the single row of memory cells coupled to the accessed word line WL. In read, the logic states of the data stored in the single row of memory cells coupled to the accessed word line WL are output from the read bit lines RBL to the column I/O circuits 120 for output at the data output ports Q.

When the DIMC processing tile 80 is operating in the digital in-memory compute mode of operation, the row decoder circuit 118 decodes a received address (Addr), selectively (and simultaneously) actuates one read word line RWL in each sub-array 113 in the memory array 112 with a word line signal pulse to access a corresponding row of memory cells 114 in each sub-array 113. The logic states of the weight data stored in the row of memory cells coupled to the accessed read word line RWL in each sub-array 113 are passed from the read bit lines RBL₀<x> to RBL_{P-1}<x> to the column I/O circuit 120 for output at the corresponding sub-array data output ports R₀ to R_{P-1}.

It will be noted that each sub-array 113 output can be considered as one subtensor/tensor for processing operations. Additionally, multiple sub-arrays 113 outputs can be grouped as a larger tensor. The grouping of sub-array outputs can be made across columns, across rows, or both. Such processing is supported through the configuration and operation of the processing circuit 123.

The architecture shown in Figure 5B presents a number of advantages for digital in-memory computation including: very wide vector access is enabled for supporting high dimensional tensor processing for an artificial neural network (ANN); hyper dimensional computing for artificial intelligence (AI) training and inference workloads is also supported; the computation is deterministic with a wide range of weight data and feature data precisions and number formats permitted for neural network applications (noting that this is a significant differentiation versus analog in-memory computation - which is limited to simplified signed/unsigned integer formats); and the solution is extendable to incorporate additional stochastic compute modes to gain area and power efficiency.

The foregoing description has provided by way of exemplary and non-limiting examples a full and informative description of the exemplary embodiment of this disclosure. However, various modifications and adaptations may become apparent to those skilled in the relevant arts in view of the foregoing description, when read in conjunction with the accompanying drawings and the appended claims. However, all such and similar modifications of the teachings of this disclosure will still fall within the scope defined in the appended claims.

## Claims

1. A circuit, comprising:
a first in-memory computation (IMC) circuit (70) comprising a first IMC processing tile (80(1)) having a processing operation clocked by a first internal clock signal (CLKINT1) ;
a second IMC circuit (70) comprising a second IMC processing tile (80(2)) having a processing operation clocked by a second internal clock signal (CLKINT2) ;
a shared compute resource circuit (80(3)) having a processing operation clocked by an internal computation clock signal (CLKINT_COMP);
a shared resource bus (72) connecting the first IMC circuit (70), second IMC circuit (70) and shared compute resource circuit (80(3)) in support of time multiplexed data communications among and between the first IMC circuit, second IMC circuit and shared compute resource circuit; and
a clock gating circuit having an input configured to receive the internal computation clock signal (CLKINT _COMP) and an output configured to supply the first internal clock signal (CLKINT1) by selectively gating a first pulse of the internal computation clock signal (CLKINT _COMP) and supply the second internal clock signal (CLKINT2) by selectively gating a second pulse of the internal computation clock signal (CLKINT _COMP).

2. The circuit of claim 1, further comprising:
a local clock generator (76) having an input configured to receive a clock signal (CLK) and an output configured to supply the internal computation clock signal (CLKINT_COMP) derived from the clock signal (CLK); and
a control circuit (78) configured to generate first control signaling input (sig1) to the local clock generator input to the local clock generator (76) to control the inclusion of the first and second pulses, for the first and second IMC circuits (70), respectively.

3. The circuit of claim 2, wherein the first and second IMC processing tiles (80(1) and 80(2)) are part of a single stall domain.

4. The circuit of claim 2 or 3, wherein the selectively gating performed by the clock gating circuit is controlled by second control signaling (sig2) generated by the control circuit (78).

5. The circuit of any one of claims 2 to 4, further comprising a resynchronization circuit (74) having a processing operation clocked by the clock signal (CLK), wherein the shared resource bus (72) connects the first IMC circuit (70), second IMC circuit, shared compute resource circuit (80(3)) and resynchronization circuit (74) in support of time multiplexed data communications among and between the first IMC circuit, second IMC circuit, shared compute resource circuit and resynchronization circuit.

6. The circuit of any one of claims 1 to 5, wherein the processing operation of the first IMC processing tile (80(1)) is a reading of weight data from a memory of the first IMC processing tile (80(1)) and outputting of the read weight data for time multiplexed data communications over the shared resource bus (72) to the shared compute resource circuit (80(3)) in response to the first internal clock signal (CLK1).

7. The circuit of claim 6, wherein the processing operation of the shared compute resource circuit (80(3)) is a processing of the read weight data received from the first IMC processing tile in response to the internal computation clock signal (CLKINT _COMP).

8. The circuit of any one of claims 1 to 5, wherein the processing operation of the second IMC processing tile is a reading of weight data from a memory of the second IMC processing tile and outputting of the read weight data for time multiplexed data communications over the shared resource bus (72) to the shared compute resource circuit (80(3)) in response to the second internal clock signal (CLK2).

9. The circuit of claim 8, wherein the processing operation of the shared compute resource circuit (80(3)) is a processing of the read weight data received from the second IMC processing tile in response to the internal computation clock signal (CLK).

10. The circuit of any one of claims 1 to 5, wherein the processing operation of the first IMC processing tile is an in-memory computation operation based on weight data stored in a memory of the first IMC processing tile and feature data applied to the first IMC processing tile, wherein computation output data is output, for time multiplexed data communications over the shared resource bus (72), to the shared compute resource circuit (80(3)) in response to the first internal clock signal (CLK1).

11. The circuit of claim 10, wherein the processing operation of the shared compute resource circuit (80(3)) is a processing of the computation output data received from the first IMC processing tile in response to the internal computation clock signal (CLKINT_COMP).

12. The circuit of any one of claims 1 to 5, wherein the processing operation of the second IMC processing tile is an in-memory computation operation based on weight data stored in a memory of the second IMC processing tile and feature data applied to the second IMC processing tile, wherein computation output data is output, for time multiplexed data communications over the shared resource bus (72), to the shared compute resource circuit (80(3)) in response to the second internal clock signal (CLK2).

13. The circuit of claim 12, wherein the processing operation of the shared compute resource circuit (80(3)) is a processing of the computation output data received from the second IMC processing tile (70) in response to the internal computation clock signal (CLKINT_COMP).

14. The circuit of any one of claims 1 to 13, wherein the shared compute resource circuit (80(3)) is a part of a third IMC circuit (70) connected to the shared resource bus (72).

15. A method, comprising:
receiving a clock signal (CLK);
generating an internal computation clock signal (CLKINT _COMP) derived from the clock signal (CLK) and including a number of pulses within each period of the clock signal equal to a number of in-memory computation (IMC) processing tiles of a tile cluster (46) that are included within a stall domain of a neural processing circuit (10);
selectively gating the pulses of the internal computation clock signal (CLKINT_COMP) to generate a corresponding plurality of internal clock signals (CLK1, CLK2) applied to respective ones of the IMC processing tiles of the tile cluster (46) within the stall domain;
wherein timing of processing operations performed each IMC processing tile of the tile cluster (46) within the stall domain is controlled by the internal clock signals (CLK1, CLK2) applied to that IMC processing tile;
time multiplexed passing of data communications generated by the processing operations performed by the IMC processing tiles of the tile cluster (46) over a shared resource bus (72) to a shared compute circuit (80(3)); and
processing the data communications by the shared compute circuit (80(3)) in response to the internal computation clock signal (CLKINT _COMP).

16. The method of claim 15, further comprising resynchronizing output of the shared compute circuit (80(3)) in response to the clock signal (CLK).

17. The method of claim 15 or claim 16, further comprising time multiplexed passing of output of the shared compute circuit (80(3)).

18. The method of any one of claims 15 to 17, wherein the data communications generated by the processing operation performed by each IMC processing tile comprises reading weight data from a memory of the IMC processing tile for output over the shared resource bus (72) to the shared compute resource circuit (80(3)) in response to the internal clock signal (CLK°.

19. The method of claim 18, wherein processing the data communications by the shared compute circuit (80(3)) comprises processing the read weight data received from the IMC processing tiles.

20. The method of any one of claims 15 to 17, wherein the data communications generated by the processing operation comprise computation data generated from an in-memory computation operation based on weight data stored in a memory of the IMC processing tile and feature data applied to the IMC processing tile.

21. The circuit of claim 20, wherein processing the data communications by the shared compute circuit (80(3)) comprises processing the computation data received from the IMC processing tiles.
